Europäisches Patentamt

European Patent Office

Office européen des brevets

(11) Publication number: **0 375 594**
A1

# EUROPEAN PATENT APPLICATION

(21) Application number: 89630229.6

(22) Date of filing: 19.12.89

(51) Int. Cl.⁵ **C23C 26/00, C04B 35/46,**
**H01B 3/12, H01G 4/12,**
**H01L 41/24**

(30) Priority: **23.12.88 US 289112**

(43) Date of publication of application:
**27.06.90 Bulletin 90/26**

(84) Designated Contracting States:
**DE FR GB**

(71) Applicant: **UNITED TECHNOLOGIES**
**CORPORATION**
**United Technologies Building 1, Financial**
**Plaza**
**Hartford, CT 06101(US)**

(72) Inventor: **Galasso, Francis S.**
**13 Green Manor Road**
**Manchester Connecticut 06040(US)**

(74) Representative: **Schmitz, Jean-Marie et al**
**OFFICE DENNEMEYER S.à.r.l. P.O. Box 1502**
**L-1015 Luxembourg(LU)**

(54) Preparation of thin films of ferroelectric materials.

(57) Preparation techniques are described for producing thin films of barium titanate and related perovskite type ferroelectric thin films. An aqueous solution of barium salt is combined with a organic solvent solution of a titanium salt. When the two solutions are mixed in the proper proportions a colloidal suspension is formed. The colloid can be appropriately processed to produce a thin film of barium titanate and related materials.

EP 0 375 594 A1

## Preparation of Ferroelectric Thin Films

### Technical Field

This invention relates to the preparation of barium titanate ($BaTiO_3$) and related ferroelectric materials in thin film form.

### Background Art

Barium titanate is an interesting and useful material having ferroelectric and piezoelectric characteristics which makes it useful in the field of electronics. More particularly, barium titanate is used in transducers to convert mechanical motion to electric current and to convert electric current to mechanical motion. The dielectric constant or barium titanate can be controllably varied through the imposition of an electric field. The optical characteristics of barium titanate can be varied by the application of an electric field and thus barium titanate has potential as an optical element in integrated electronic systems. Barium titanate also has been proposed for use in electronic memory systems for computers since its ferroelectric properties can be permanently altered through the application of an electric field and the state of the alteration can be subsequently detected electrically.

Barium titanate is under extensive investigation for all these applications and others. Barium titanate would be extremely useful for most of these applications in thin film form (films on the order of microns in thickness) but such films have not been easy to fabricate reliably and economically heretofore.

Accordingly it is an object of the invention to describe a technique for making thin films for barium titanate and similar materials through the use of simple chemical techniques.

### Disclosure of Invention

According to the invention barium titanate can be produced by mixing an aqueous solution of a barium compound with an organic solvent solution of a titanium compound. When the aqueous and organic solutions are mixed under proper conditions they form a colloidal suspension of extremely fine particles. This suspension can be applied to a substrate and the coated substrate can then be dried and fired to form a thin film of polycrystalline barium titanate particles whose dimensions are on the order of 50-300 Å.

The foregoing and other features and advantages of the present invention will become more apparent from the following description.

### Best Mode for Carrying Out the Invention

The invention is similar in some respects to the sol gel type processing which is currently a method of some interest in the preparation of ceramic materials such as silica and alumina. It differs from sol gel processing however in that the reactants are not dissolved in an organic solvent which is applied to a surface and then hydrolyzed, dried and fired. That technique produces a very thin coating and multiple dips and heatings are necessary to produce usefully thick coatings. The liquid precursor that I employ is not a true sol but more accurately a colloidal suspension and when it is applied to a surface, coatings up to 1 micron (i.e. 0.1-1 micron) can be formed in a single application because it is applied as a solid suspension rather than liquid solution.

The invention comprises mixing two liquid solutions to form a colloidal gel. One of the liquid components is an aqueous solution of a barium salt. I have used barium acetate as it is widely available and has a substantial solubility in water. There are only a few other barium salts that are as soluble in water as barium acetate. The few that appear to have useful solubilities include barium nitrite, barium chloride, and barium formate. These may be substituted in whole or in part for barium acetate, but it will be necessary to work with the process using alternate salts to insure that the nonbarium ion does not interfere with the subsequent reactions. Barium acetate, $Ba(OOCCH_3)_2$ has an innocuous, readily decomposable anion.

The second liquid component is a solution using on an organic solvent such as methanol, ethanol, etc. containing a titanium salt. Again it is necessary to correlate the solvent and the salt to insure that the requisite solubility exists for the combination. I have used ethanol and titanium ethoxide. I believe other equivalents might include titanium methoxide, titanium butoxide, and titanium propoxide dissolved in methanol, butanol or propanol.

These solutions are made separately and then mixed together to form a colloid. Obviously the solutions are formulated and mixed to produce the proper ratio of Ba and Ti. The concentration of the solutions can also be controlled to change the colloid viscosity. The colloid can be applied to a substrate using dipping, spraying, painting, wiping or other equivalent techniques. Multiple colloid applications and/or colloid viscosity control can be used to produce the desired thickness. The colloid coating can then be heated to a moderate temperature (100-300°C) to remove the solvent remnants and can than be heated at an elevated temperature (500-1000°C) to drive off any water of hydration and the like and to react the barium and the titanium. When the process is carried out with the proper proportions a coating is formed which upon X-ray analysis is shown to contain fine particles or crystallites of barium titanate whose size ranges from about 50-300 Å and specifically by actual analysis about 160-210 Å in average diameter.

Example 1 listed below gives a complete recipe for the fabrication of a thin film of barium titanate.

Example 1

a) Dissolve 1 gram of barium acetate in 25 cc of $H_2O$.

b) Dissolve 0.9 gram of titanium ethoxide in 25 cc of ethanol.

c) The results of steps a and b are mixed together (pH is about 6.5) and a fine suspension results.

d) This suspension is spread on a quartz slide (Pt foil could also be used).

e) Initial drying is performed at 120°C for 1 hour, final heating is performed at 800°C for 1 hour.

f) The result is a 1 micron coating which is analyzed using X-ray techniques to be $BaTiO_3$ with a 170-190 Å crystallite size.

Barium titanate has perovskite structure and many other compounds of the general formula $ABO_3$ with a similar structure form solid solutions with barium titanate. This permits the modification of the properties of a barium titanate base film over wide ranges. For example, barium acetate dissolved in water and titanium methoxide dissolved in ethanol along with strontium 2,4 pentanedione dissolved in ethanol can be mixed in proper proportions to form a colloidal gel which can be applied as a thin film, dried at 120°C and heated at 800°C to form a perovskite material (as analyzed by x-rays) containing approximately 30% strontium as a substitute for some of the barium. Other elements selected from the group consisting of rubidium, cesium, and the rare earth elements may be similarly employed. Example 2 listed below gives the exact details of the preparation of this material.

Example 2

a) Dissolve 0.30 grams of barium acetate in 25 cc of water.

b) Dissolve 0.40 gram of titanium ethoxide and 0.16 gram Sr 2,4 pentanedione in 25 cc of ethanol.

c) Mix a and b solutions.

d) Spread on quartz slide or platinum foil.

e) Air dry.

f) Fire at 800°C for 1 hour.

g) The result is a 1 micron thick coating which is analyzed to be $(Ba_{0.7}Sr_{0.3})TiO_3$

Accordingly, the present invention describes methods for using simple economical chemical process techniques to produce thin films of barium titanate and other films of even complex perovskite ferroelectric materials such as $(Ba_{0.92} Ca_{0.08}) (Ti_{0.92} Zr 0.08) O_3$.

Although this invention has been shown and described with respect to detailed embodiments thereof, it will be understood by those skilled in the art that various changes in form and detail thereof may be made without departing from the spirit and scope of the claimed invention.

Claims

1. Method for making a thin film of a barium titanate type ferroelectric material including the steps of:

a) dissolving a barium salt in water;

b) dissolving titanium salt in an organic solvent;

c) mixing the solutions prepared in steps a and b to produce a colloidal suspension;

d) applying the colloidal suspension in a thin layer on a substrate;

e) drying the colloidal suspension layer to drive off the solvents; and

f) firing the dried colloidal suspension to form the barium titanate type thin film.

2. A method as in claim 1 wherein another element selected from the group consisting of strontium, rubidium, cesium, and the rare earth elements and mixture thereof is substituted in part for some of the barium.

## DOCUMENTS CONSIDERED TO BE RELEVANT

| Category | Citation of document with indication, where appropriate, of relevant passages | Relevant to claim | CLASSIFICATION OF THE APPLICATION (Int Cl⁵) |
|---|---|---|---|
| Y | <u>SU - A - 895 020</u> (MOSCOW LOMONOSSOV UNIVERSITY) * Totality * | 1 | C 23 C 26/00 C 04 B 35/46 H 01 B 3/12 H 01 G 4/12 H 01 L 41/24 |
| Y | <u>FR - A - 2 570 373</u> (CENTRE NATIONAL DE RECHERCHE SCIENTIFIQUE) * Claim 1; example; page 4, lines 15-22 * | 1 | |
| A | <u>JP - A - 61-67 964</u> (MATSUSHITA) * Totality * | 1 | |

TECHNICAL FIELDS SEARCHED (Int Cl⁵)

C 23 C
C 04 B
H 01 B
H 01 G
H 01 L

The present search report has been drawn up for all claims

| Place of search | Date of completion of the search | Examiner |
|---|---|---|
| VIENNA | 23-03-1990 | MARCHART |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82